# EUROPÄISCHE PATENTSCHRIFT

(11) **EP 0 905 797 B1**
(45) Veröffentlichungstag und Bekanntmachung des Hinweises auf die Patenterteilung: **10.02.2010**
(21) Anmeldenummer: 98116218.3
(22) Anmeldetag: 27.08.1998
(51) Int. Cl.: H01L 33/00

(54) **Halbleiterlichtquelle und Verfahren zu ihrer Herstellung**
Semiconductor light source and method of fabrication
Source lumineuse à semi-conducteur et méthode de fabricaton

(30) Priorität: 29.09.1997 DE 19742963
(43) Veröffentlichungstag der Anmeldung: 31.03.1999
(60) Teilanmeldung: 09180431.0
(73) Patentinhaber: OSRAM Opto Semiconductors GmbH, 93055 Regensburg (DE)
(72) Erfinder: Heinen, Jochen, 85540 Haar (DE)
(74) Vertreter: Epping - Hermann - Fischer

(56) Entgegenhaltungen:
- EP-A- 0 720 241
- US-A- 5 153 889
- US-A- 5 453 405
- US-A- 5 502 316

## Beschreibung

Die Erfindung betrifft eine Halbleiterlichtquelle mit einem epitaktisch gewachsenen Schichtenstapel nach dem Oberbegriff des Anspruchs 1 und ein Verfahren zu ihrer Herstellung gemäß Anspruch 26.

Beispiele für Lichtquellen der genannten Art sind transparente Infrarotdioden (IREDs) und Leuchtdioden (LEDs). Die Schichten des Schichtenstapels solcher Lichtquellen sind auf einem Wachstumssubstrat in Form eines Kristalls epitaktisch aufeinander gewachsen. Ein Teil der im Schichtenstapel erzeugten Photonen wird aus dem Stapel in Richtung zum Wachstumssubstrat emittiert und dort absorbiert.

Für derartige Halbleiterlichtquellen möglichst hoher optischer Leistung wird versucht, die Absorption im Wachstumssubstrat weitgehend zu vermeiden. Mittel hierzu sind - außer der in wenigen Fällen möglichen Verwendung von für die Photonen transparenten Wachstumssubstraten - eingefügte Bragg-Reflektoren aus Halbleitermaterial zwischen dem Wachstumssubstrat und dem gewachsenen Schichtenstapel oder das nachträgliche Anbringen eines für die Photonen transparenten Stützkörpers an den Schichtenstapel, beispielsweise durch Waferbonden.

Beim nachträglichen Anbringen des transparenten Stützkörpers an den Schichtenstapel wird der Stützkörper flächig und derart innig mit der vom Wachstumssubstrat abgekehrten Oberfläche des Schichtenstapels verbunden, daß der Stützkörper ähnlich unmittelbar fest mit dem Schichtenstapel verbunden ist, wie das Wachstumssubstrat selbst. Dieses unmittelbare Anbringen wird beispiesweise durch Anschmelzen oder Anwachsen des transparenten Stützkörpers an den Schichtenstapel vorgenommen. Nach dem Anbringen wird das Wachstumssubstrat vom Schichtenstapel entfernt, wonach Schichtenstapel und transparenter Stützkörper gemeinsam als ähnlich einheitlicher Verbundkörper wie vorher Schichtenstapel und Wachstumssubstrat vorliegen und der transparente Stützkörper den Schichtenstapel jetzt wie ursprünglich das Wachstumssubstrats stützt. In diesem Zustand wird der Schichtenstapel elektrisch kontaktiert. Ein solches Verfahren wird in US 5,453,405 sowie in EP 0 720 241 A2 und US 5,502,316 beschrieben.

Der im Anspruch 1 angegebenen Erfindung liegt die Aufgabe zugrunde, eine Halbleiterlichtquelle mit geringer Photonenabsorption bereitzustellen, die sowohl baulich einfacher als auch einfacher herzustellen ist.

Bei der erfindungsgemäßen Halbleiterlichtquelle ist vorteilhafterweise weder ein Photonen absorbierendes Wachstumssubstrat noch ein Stützkörper zum Stützen des Schichtenstapels vorhanden, der innig mit dem Schichtenstapel zu einem einheitlichen Verbundkörper verbunden und für im Schichtenstapel erzeugte Photonen transparent ist und der den Aufbau und die Herstellung der Lichtquelle verkompliziert.

Die erfindungsgemäße Lichtquelle besteht im wesentlichen nur noch aus dem Schichtenstapel einer geringen Gesamtdicke von höchstens 50 µm allein, der zur elektrischen Kontaktierung und mechanischen Stabilität an einem gesonderten Trägerkörper angeordnet und durch ein wenig Aufwand erforderndes gesondertes Verbindungsmittel mit diesem Körper verbunden ist. Eine die Herstellung verkomplizierende innige flächige Verbindung zwischen der Oberfläche dieses dünnen Schichtenstapels und einem transparenten Stützkörper ist vorteilhafterweise nicht mehr erforderlich. Der Trägerkörper besteht aus elektrisch leitendem Material und weist elektrisch voneinander getrennte Kontakte auf, wobei ein Kontakt zweckmäßigerweise ein von der elektrisch leitenden Oberfläche des Trägerkörpers isolierter Kontakt ist und ein elektrisch von diesem Kontakt getrennter anderer Kontakt von der Oberfläche des Trägerkörpers selbst gebildet ist.

Die Kontakte sind vorteilhafterweise auf einer dem Schichtenstapel zugekehrten Oberfläche des Trägerkörpers angeordnet, wobei sich ein besonders kurzer und einfacher Anschluß der Halbleitermaterialien verschiedenen Leitfähigkeitstyps des Schichtenstapels auf beiden Seiten dessen optisch aktiven Übergangs an diese Kontakte dann ergibt, wenn diese Materialien auf der dem Trägerkörper zugekehrten Oberfläche des Stapels kontaktiert sind, weil sich dann die Kontakte auf der Oberfläche des Trägerkörpers und diese Halbleitermaterialien kontaktierende Halbleiterkontakte auf der dieser Oberfläche zugekehrten Oberfläche des Schichtenstapels unmittelbar gegenüberliegen und berühren können.

Aufgrund der Bauweise der erfindungsgemäßen Lichtquelle kann eine dem Trägerkörper zugekehrte Oberfläche des Schichtenstapels eine brechende Fläche sein, die an ein optisches Medium mit einer relativ zu einer Brechzahl des Schichtenstapels deutlich kleineren Brechzahl, beispielsweise Luft, grenzt und aufgrund des relativ großen Brechzahlsprungs im Schichtenstapel erzeugte Photonen teilweise reflektiert, die dann nicht aus dem Schichtenstapel in den Trägerkörper gelangen, sondern zur optischen Leistung der Lichtquelle beitragen.

Besonders vorteilhaft ist es, wenn an der dem Trägerkörper zugekehrten Oberfläche des Schichtenstapels eine Reflektoreinrichtung zum Reflektieren der im Schichtenstapel erzeugten und auf diese Fläche treffenden Photonen zurück in den Schichtenstapel ausgebildet ist (Anspruch 2).

Dies hat den Vorteil zum einen, daß alle im Schichtenstapel erzeugten Photonen, die auf die Reflektoreinrichtung treffen, nicht in den gesonderten Trägerkörper gelangen, sondern in Richtung vom Trägerkörper fort reflektiert werden und zur optischen Leistung der erfindungsgemäßen Lichtquelle beitragen können, zum andern, daß der gesonderte Trägerkörper auch bei Lichtquellen hoher optischer Leistung aus einem beliebigen Material bestehen kann, insbesondere aus einem die im Schichtenstapel erzeugten Photonen absorbierenden Material.

Als Reflektoreinrichtung sind alle reflektierend wirkenden Mittel geeignet, die an der dem Trägerkörper zugekehrten Oberfläche des Schichtenstapels ausgebildet werden können wie beispielsweise eine auf dieser Oberfläche aufgebrachte reflektierende Schicht oder ein in dieser Oberfläche ausgebildetes reflektierendes optisches Gitter, beispielsweise ein Braggspiegel.

Bei einer bevorzugten und vorteilhaften Ausgestaltung der erfindungsgemäßen Lichtquelle weist die Reflektoreinrichtung einen auf der dem Trägerkörper zugekehrten Oberfläche des Schichtenstapels angeordneten reflektierenden Kontakt auf (Anspruch 3). Dieser Kontakt kann zum elektrischen Anschließen des Schichtenstapels an den Trägerkörper verwendet werden, und da er reflektierend wirkt, sind keine zusätzlichen reflektierend wirkenden Mittel notwendig. Dies vereinfacht die Herstellung der erfindungsgemäßen Lichtquelle.

Der Schichtenstapel der erfindungsgemäßen Lichtquelle kann vorteilhafterweise nur aus den für die Funktion der Halbleiterlichtquelle allein notwendigen epitaktisch gewachsenen Schichten bestehen.

Eine typische Gesamtdicke von auf Wachstumssubstraten gewachsenen und nur aus den für die Funktion der Lichtquelle notwendigen epitaktisch gewachsenen Schichten allein bestehenden Schichtenstapeln bekannter Diodenlichtquellen wie LEDs und IREDS insbesonderer hoher optischer Leistung liegt im Bereich zwischen 3 µm und 15 µm. Mit der Erfindung können vorteilhafterweise solche Diodenlichtquellen mit derart dünnen Schichtenstapeln realisiert werden und entsprechend kann bei der erfindungsgemäßen Lichtquelle vorteilhafterweise der alleinige Schichtenstapel eine solche geringe Gesamtdicke im Bereich von nur 3 µm bis 15 µm aufweisen (Anspruch 4).

Insbesondere ist die Erfindung vorteilhafterweise zur Realisierung von IREDs und LEDs hoher optischer Leistung geeignet und entsprechend ist in diesem Fall der Schichtenstapel der erfindungsgemäßen Lichtquelle der Schichtenstapel einer IRED (Anspruch 5) oder einer LED (Anspruch 6), wobei es in diesem Fall überdies vorteilhaft ist, eine Reflektoreinrichtung nach Anspruch 2 zu verwenden.

Die Erfindung ist aber nicht auf solche Diodenlichquellen beschränkt, sondern auch auf andere Halbleiterlichtquellen, beispielsweise Halbleiterlaser anwendbar, wobei unter Umständen das Problem eines Austritts von im Schichtenstapel erzeugten Photonen durch die dem Trägerkörper zugekehrte Oberfläche unbedeutend sein kann, so daß auf Maßnahmen zur Verhinderung eines solchen Austritts von vorneherein verzichtet werden kann.

Das gesonderte Verbindungsmittel zum aneinander befestigen von Schichtenstapel und gesondertem Trägerkörper besteht vorzugsweise aus einem eine feste Verbindung zwischen dem Schichtenstapel und diesem Trägerkörper herstellenden Haftmittel (Anspruch 7), vorzugsweise ein Klebstoff (Anspruch 8) und/oder ein Lot (Anspruch 9).

Lot und/oder elektrisch leitender Klebstoff werden vorzugsweise dort verwendet, wo eine elektrisch leitende Verbindung nicht stört oder gar notwendig ist, elektrisch isolierender Klebstoff dort, wo eine elektrisch leitende Verbindung zu vermeiden ist.

Auch andere Verbindungsmittel, beispielsweise eine Klemmverbindung, können verwendet werden.

Eine erfindungsgemäße Diodenlichtquelle, insbesondere eine Quelle hoher optischer Leistung, kann vorteilhafterweise derart baulich einfach ausgebildet sein, daß der Schichtenstapel
- Schichten aus Halbleitermaterial voneinander verschiedenen Leitfähigkeitstyps aufweist, zwischen denen ein optisch aktiver Übergang von einem zu einem anderen Leitfähigkeitstyp zur Erzeugung der Photonen ausgebildet ist, und
- Halbleitermaterial eines Leitfähigkeitstyps des Schichtenstapels und Halbleitermaterial des anderen Leitfähigkeitstyps elektrisch voneinander getrennt am Trägerkörper kontaktiert sind (Anspruch 10).

In diesem Fall ist es zweckmäßig wenn der Trägerkörper
- einen elektrischen Kontakt, an den Halbleitermaterial eines Leitfähigkeitstyps des Schichtenstapels angeschlossen ist, und
- einen von dem einen Kontakt getrennten anderen elektrischen Kontakt aufweist, an den Halbleitermaterial des anderen Leitfähigkeitstyps des Schichtenstapels angeschlossen ist (Anspruch 11).

Ein elektrischer Anschluß von Halbleitermaterial des Schichtenstapels der erfindungsgemäßen Lichtquelle an einen Kontakt des Trägerkörpers ist vorzugsweise durch einen dieses Halbleitermaterial unmittelbar kontaktierenden Halbleiterkontakt an diesen Kontakt des Trägerkörpers angeschlossen (Anspruch 12).

Der Halbleiterkontakt ist vorzugsweise ein ohmscher Kontakt, kann unter Umständen aber auch ein Schottky-Kontakt sein.

Zum Verbinden eines Kontaktes des Trägerkörpers mit einem Halbleiterkontakt wird vorzugsweise Lot und/oder leitender Klebstoff verwendet.

Bei Diodenlichtquellen sind die Schichten aus Halbleitermaterial voneinander verschiedenen Leitfähigkeitstyps, zwischen denen der optisch aktive Übergang vom einen zum davon verschiedenen anderen Leitfähigkeitstyp ausgebildet ist, üblicherweise parallel zu einer Ebene der Schichten übereinander angeordnet, so daß sie sich senkrecht zu dieser Ebene auf verschiedenen Seiten des Übergangs befinden. Entsprechend muß bei einer solchen Diodenlichtquelle Halbleitermaterial eines Leitfähigkeitstyps auf einer Seite und Halbleitermaterial des von diesem einen Leitfähigkeitstyp verschiedenen anderen Leitfähigkeitstyps auf der anderen Seite des Übergangs kontaktiert und an die elektrisch voneinander getrennten Kontakte des Trägerkörpers angeschlossen werden.

Halbleitermaterial eines Leitfähigkeitstyps und Halbleitermaterial des davon verschiedenen anderen Leitfähigkeitstyps des Schichtenstapels der erfindungsgemäßen Lichtquelle können in einem solchen Fall jedoch vorteilhafterweise auf der gleichen Seite des Übergangs, aber elektrisch voneinander getrennt an die elektrisch voneinander getrennten Kontakte des Trägerkörpers angeschlossen sein, wenn
- der Schichtenstapel in einer zu einer Ebene der Schichten im wesentlichen parallelen Oberfläche eine Vertiefung aufweist, die sich von dieser Oberfläche aus in Richtung senkrecht zur Ebene der Schichten durch einen Übergang von Halbleitermaterial eines Leitfähigkeitstyps zu Halbleitermaterial eines vom einen Leitfähigkeitstyp verschiedenen anderen Leitfähigkeitstyps des Schichtenstapels hindurch erstreckt, und wenn
- das Halbleitermaterial des einen Leitfähigkeitstyps an einen Kontakt des Trägerkörpers und das Halbleitermaterial des anderen Leitfähigkeitstyps in der Vertiefung an einen elektrisch von diesem einen Kontakt des Trägerkörpers getrennten anderen Kontakt des Trägerkörpers angeschlossen ist (Anspruch 13).

Der Schichtenstapel ist dabei vorzugsweise derart flach auf dem Trägerkörper angeordnet, daß die Oberfläche des Schichtenstapels, in der die Vertiefung ausgebildet ist, dem Trägerkörper zugekehrt ist (Anspruch 14).

Der Anschluß der Halbleitermaterialien voneinander verschiedenen Leitfähigkeitstyps des Schichtenstapels an die voneinander getrennten Kontakte des Trägerkörpers kann in diesem Fall vorteilhafterweise auf besonders kurzem Weg hergestellt werden, wenn die elektrisch voneinander getrennten Kontakte des Trägerkörpers auf einer dem Schichtenstapel zugekehrten Oberfläche des Trägerkörpers angeordnet sind, vorzugsweise wie folgt:

Auf der dem Trägerkörper zugekehrten Oberfläche des Schichtenstapels sind ein Halbleiterkontakt, der zwischen dieser Oberfläche und dem optisch aktiven Übergang befindliches Halbleitermaterial des Stapels unmittelbar kontaktiert, und ein anderer Kontakt angeordnet, der elektrisch von diesem Halbleiterkontakt und dem Halbleitermaterial zwischen der Oberfläche und dem optisch aktiven Übergang des Stapels getrennt ist.

Der Halbleiterkontakt ist an einen Kontakt des Trägerkörpers und der andere Kontakt des Schichtenstapels an einen elektrisch von diesem einen Kontakt des Trägerkörpers getrennten anderen Kontakt des Trägerkörpers angeschlossen, beispielsweise durch unmittelbares Berühren.

In der Vertiefung ist ein Halbleiterkontakt angeordnet, der Halbleitermaterial des Schichtenstapels, das sich auf der vom Trägerkörper abgekehrten Seite des optisch aktiven Übergangs des Stapels befindet, unmittelbar kontaktiert. Dieser Halbleiterkontakt in der Vertiefung ist elektrisch vom Halbleitermaterial des einen Leitfähigkeitstyps auf der dem Trägerkörper zugekehrten Seite des optisch aktiven Übergangs, von dem dieses Material kontaktierenden Halbleiterkontakt und von dem mit diesem Anschlußkontakt verbundenen Kontakt des Trägerkörpers getrennt, dagegen elektrisch mit dem anderen Kontakt des Schichtenstapels verbunden.

Der mit dem Halbleiterkontakt in der Vertiefung verbundene andere Kontakt des Schichtenstapels und eine elektrische Verbindung dieser beiden Kontakte können vorteilhafterweise aus dem gleichen Material wie dieser Halbleiterkontakt bestehen, wobei die Verbindung auf einer Seitenwand der Vertiefung aufgebracht sein kann.

Vorzugsweise ist es so eingerichtet, daß der Schichtenstapel zwei voneinander abgekehrte und in einem Winkel zur Ebene der Schichten stehende Endflächen aufweist, welche die Oberfläche des Schichtenstapels, in der die Vertiefung ausgebildet ist, auf zueinander entgegengesetzten Seiten begrenzen, und daß sich die Vertiefung in dieser Oberfläche von einer Endfläche bis zur anderen erstreckt (Anspruch 15).

Auf der vom Trägerkörper abgekehrten Seite des optisch aktiven Übergangs befindliches Halbleitermaterial des Schichtenstapels weist vorzugsweise eine hohe elektrische Leitfähigkeit senkrecht zur Ebene der Schichten des Schichtenstapels auf (Anspruch 16).

Die von der erfindungsgemäßen Lichtquelle abgegebene optische Leistung wird im Schichtenstapel erzeugt und tritt durch die Oberfläche des Schichtenstapels aus. Zu dieser optischen Leistung sollten möglichst alle im Schichtenstapel erzeugten Photonen beitragen. Dazu ist zum einen notwendig, daß möglichtst wenig dieser Photonen im Stapel absorbiert werden, d.h. der Stapel sollte für diese Photonen möglichst transparent sein, zum anderen sollten möglichst viele dieser Photonen, am besten alle, durch die Oberfläche des Schichtenstapels austreten..

Größtmögliche Transparenz des Schichtenstapels wird erreicht, wenn die Schichten des Schichtenstapels, allenfalls ausgenommen in einem Bereich eines optisch aktiven Übergangs, für im Schichtenstapel erzeugte Photonen transparent sind (Anspruch 17).

Zur Begünstigung des Austritts der im Schichtenstapel erzeugten Photonen aus dem Schichtenstapel ist zweckmäßigerweise eine Einrichtung zur Erleichterung eines Austritts von im Schichtenstapel erzeugten Photonen aus dem Schichtenstapel vorgesehen (Anspruch 18).

Als Einrichtung zur Erleichterung des Austritts von Photonen ist jedes Mittel geeignet, das den Austritt der Photonen durch die Oberfläche des Schichtenstapels fördert. Beispielsweise kann ein solches Mittel eine auf die Oberfläche aufgebrachte Antireflexschicht sein, die den Brechzahlsprung an der optisch brechenden Oberfläche von höherer Brechzahl im Inneren des Stapels zu niedrigerer Brechzahl außerhalb des Stapels herabsetzt und so den Austritt der Photonen erleichtert.

Allerdings ist das Aufbringen einer zusätzlichen Reflexschicht oft unerwünscht, beispielsweise weil die Herstellung der Lichtquelle nicht unerheblich aufwendig und verteuert wird.

Ein Weg zu einer einfachen Realisierung einer Einrichtung zur Erleichterung des Austritts von Photonen besteht in der Vermeidung von planparallelen reflektierenden Oberflächenabschnitten des Schichtenstapels, d.h. voneinander abgekehrte Oberflächenabschnitte sollen nicht eben und/oder parallel zueinander sein. Derartige Oberflächenabschnitte können allein durch geometrische Gestaltgebung des Schichtenstapels und damit ohne großen Aufwand realisiert werden.

Planparallele reflektierenden Oberflächenabschnitten können vermieden werden, wenn die Einrichtung zur Erleichterung des Austritts von Photonen so ausgebildet ist, daß sie
- schräg in einem Winkel zueinander angeordnete Oberflächenabschnitte aufweist (Anspruch 19) und/oder
- ein auf der Oberfläche des Schichtenstapels ausgebildetes Relief aufweist (Anspruch 20), das vorzugsweise fein strukturiert ist.

Schräg in einem Winkel zueinander angeordnete Oberflächenabschnitte können beispielsweise zwei voneinander abgekehrte und in einem Winkel zur Ebene der Schichten stehende Endflächen, die in dieser Ebene schräg in einem Winkel zueinander verlaufen und/oder von denen zumindest eine Endfläche schräg in einem Winkel zur Ebene angeordnet ist.

Ein auf der Oberfläche des Schichtenstapels ausgebildetes fein strukturiertes Relief kann durch Aufrauhen der Oberfläche oder durch eine unebene Mikrostrukturierung der Oberfläche erzeugt werden. Ein derartiges Relief ist vorzugsweise auf der vom Trägerkörper abgekehrten Oberfläche des Schichtenstapels ausgebildet, kann aber auch auf dessen dem Trägerkörper zugekehrten Oberfläche und auf allen anderen Oberflächenabschhnitten vorgesehen sein.

Schräg in einem Winkel zur Ebene der Schichten angeordnete Oberflächenabschnitte des Schichtenstapels, darunter eine, mehrere oder alle Endflächen des Stapels und/oder zumindest eine Wandfläche einer Vertiefung sind vorzugsweise in Winkeln kleiner als 30° bei unvergossenen und kleiner als 40° bei vergossenen erfindungsgemäßen Lichtquellen zur Ebene geneigt, wobei die Richtung der Neigung beliebig ist.

Generell können in einem Winkel zur Ebene der Schichten angeordnete Oberflächenbereiche des Schichtenstapels beliebig geformt sein. Auch die Form der Grundfläche oder des Umrisses des Schichtenstapels in senkrechter Projektion auf eine zur Ebene der Schichten parallele Ebene ist generell beliebig wählbar.

Vorteilhafterweise kann der erfindungsgemäße Schichtenstapel in herkömmlicher Weise III-V-Halbleitermaterial aufweisen (Anspruch 21), darunter alle gebräuchlichen III-V-Verbindungen von In, GA, Al, As, P, N auf GaAs-, InP-, GaP- oder GaN-Basis.

Ein optisch aktiver Übergang kann ein pn- oder pin-Übergang sein. Vorteilhafterweise kann der erfindungsgemäße Schichtenstapel in herkömmlicher Weise so ausgebildet sein, daß der optisch aktive Übergang eine zwischen zwei Schichten aus Halbleitermaterial zueinander verschiedenen Leitfähigkeitstyps des Schichtenstapels angeordnete aktive Schicht aufweist, in der Photonen erzeugbar sind (Anspruch 22). Bis auf die aktive Schicht sind alle anderen Schichten aus Halbleitermaterial des Schichtenstapels möglichst transparent.

Der Trägerkörper besteht vorteilhafterweise aus einem Material, das einen ähnlichen thermischen Ausdehnungskoeffizienten wie der Schichtenstapel aufweist (Anspruch 23), d.h. die thermischen Ausdehnungskoeffizienten der Materialien des Trägerkörpers und des Schichtenstapels weichen bei den Temperaturen, die beim Betrieb der erfindungsgemäßen Halbleiterlichtquelle auftreten oder denen die Quelle ausgesetzt wird, allenfalls so gering voneinander ab, daß keine schädlichen temperaturbedingten Verformungen des Schichtenstapels auftreten, welche dessen optische Qualität beeinträchtigen und eine optische und/oder mechanische Langzeitstabilität der erfindungsgemäßen Lichtquelle beeinträchtigen können.

Der Trägerkörper besteht vorzugsweise aus einem gut wärmeleitenden Material (Anspruch 24), das eine gute Wärmeableitung vom Schichtenstapel fort gewährleistet.

Ein für den Trägerkörper gut geeignetes Material, dessen thermischer Ausdehnungskoeffizient gut an den des Schichtenstapels angepaßt ist und das eine gute Wärmeleitfähigkeit aufweist, ist Silizium.

Der elektrische Anschluß der erfindungsgemäßen Lichtquelle von außen erfolgt über die elektrisch voneinander getrennten Kontakte des Trägerkörpers, beispielsweise durch Bonddrähte und/oder Lot.

Es kann vorteilhaft sein, wenn der elektrische Anschluß der erfindungsgemäßen Lichtquelle von außen über die elektrisch voneinander getrennten Kontakte auf dem Trägerkörper so ausgeführt ist, daß zum einen der elektrisch isolierte Kontakt des Trägerkörpers und zum anderen sein von der Oberfläche des Trägerkörpers selbst gebildete Kontakt indirekt durch den elektrisch leitenden Trägerkörper hindurch von außen kontaktiert ist, vorzugsweise so, daß eine vom Schichtenstapel abgekehrte Oberfläche des Trägerkörpers kontaktiert ist (Anspruch 25).

Die erfindungsgemäße Lichtquelle wird vorteilhafterweise so hergestellt, daß auf einem Wachstumssubstrat epitaktisch ein für die Lichtquelle bestimmter Schichtenstapel gewachsen, der mit dem Wachstumssubstrat verbundene Schichtenstapel auf einem Trägerkörper, der aus elektrisch leitendem Material besteht, elektrisch voneinander getrennten Kontakte aufweist, ein Kontakt des Trägerkörpers vom Trägerkörper elektrisch isoliert ist und ein elektrisch von dem einen Kontakt getrennter anderer Kontakt des Trägerkörpers vom den Trägerkörper selbst gebildet wird, angeordnet und mit dem Verbindungsmittel befestigt und elektrisch kontaktiert wird, und danach die derart auf dem Trägerkörper befestigte Schichtenfolge vom Wachstumssubstrat getrennt wird (Anspruch 26).

Dieses Verfahren wird in bezug auf das Trennen des Schichtenstapels vom Wachstumssubstrat bevorzugterweise so ausgeführt, daß auf dem Wachstumssubstrat epitaktisch eine Zwischenschicht aus einem Material gewachsen wird, das mit einem selektiv wirkenden Ätzmittel ätzbar ist, welches die Materialien der Schichten des Schichtenstapels nicht oder weniger stark angreift, als das Material der Zwischenschicht, daß auf der Zwischenschicht epitaktisch die Schichten des Schichtenstapels gewachsen werden, und daß zum Trennen des Schichtenstapels vom Wachstumssubstrat die Zwischenschicht mit dem selektiv wirkenden Ätzmittel geätzt wird.(Anspruch 27). Dieses Verfahren kann beispielsweise mit einem Wachstumssubstrat aus GaAs, einem Schichtenstapel auf der Basis von InGaAlAs, einer Zwischenschicht aus AlAs und einem flußsäurehaltigen Ätzmittel aus durchgeführt werden.

Bei der Herstellung der erfindungsgemäßen Halbleiterlichtquellen wird vorteilhafterweise so vorgegangen, daß mehrere Schichtenstapel im Waferverbund als Inseln oder Meseten im Raster mehrerer Trägerkörper präpariert werden, wobei die Form der Grundfläche jedes Schichtenstapels beliebig wählbar ist, vorzugsweise mit spitzwinklig zueinander geordneten Seiten.

Die Erfindung wird in der nachfolgenden Beschreibung an Hand der Figur beispielhaft näher erläutert. Die Figur zeigt eine Seitenansicht eines Ausführungsbeispiels einer erfindungsgemäßen Halbleiterlichtquelle.

Die Figur ist schematisch und nicht maßstäblich.

In der Figur ist der Schichtenstapel mit 1 und der Trägerkörper mit 2 bezeichnet. Die Schichten des Schichtenstapels 1 sind parallel zu einer definierten Ebene 100 der Schichten angeordnet. Der Schichtenstapel 1 weist zwei voneinander abgekehrte Oberflächen 14 und 14' auf, zwischen denen die Gesamtdicke d des Stapels 1 gemessen ist.

Erfindungswesentlich ist, daß der Schichtenstapel 1 in der Gesamtdicke d von höchstens 50 µm allein, d.h. ohne ein Wachstumssubstrat und/oder einen sonstigen innig mit dem Stapel 1 verbundenen Stützkörper an dem gesonderten, elektrisch voneinander getrennte Kontakte 21 und 22 aufweisenden Trägerkörper 2 angeordnet ist, und daß Schichtenstapel 1 und Trägerkörper 2 durch ein gesondertes Verbindungsmittel 3 aneinander befestigt sind.

Der Schichtenstapel 1 kann jeden Aufbau aus epitaktisch aufeinander gewachsenen Schichten aufweisen, den eine Halbleiterlichtquelle haben kann.

Bei dem dargestellten Ausführungsbeispiel ist die Halbleiterlichtquelle insbesondere eine Diodenlichtquelle, bei welcher der Schichtenstapel 1 aus epitaktisch aufeinander gewachsenen Schichten aus Halbleitermaterial voneinander verschiedenen Leitfähigkeitstyps besteht, zwischen denen zumindest ein Photonen erzeugender optisch aktiver Übergang von einem zum anderen Leitfähigkeitstyp ausgebildet ist, wobei Halbleitermaterial eines Leitfähigkeitstyps und Halbleitermaterial des anderen Leitfähigkeitstyps des Schichtenstapels 1 voneinander getrennt elektrisch kontaktiert sind.

Eine typische Gesamtdicke d eines Schichtenstapels 1 herkömmlicher Diodenlichtquellen liegt im Bereich zwischen 3 µm und 15 µm. Auch bei einer erfindungsgemäßen Diodenlichquelle weist der allein am gesonderten Trägerkörper 2 angeordnete Schichtenstapel 1 vorteilhafterweise eine Gesamtdicke d im Bereich von 3 µm bis 15 µm auf.

Wie bei herkömmlichen Diodenlichtquellen ist auch bei einer erfindungsgemäßen Diodenlichtquelle dem optisch aktiven Übergang üblicherweise wenigstens eine aktive Schicht des Schichtenstapels 1 zugeordnet, in der Photonen dieses Übergangs erzeugt werden.

Bei den in der Figur dargestellten Diodenlichtquellen ist eine einfachste Form eines Schichtenstapels 1 angenommen. Dieser besteht aus einer Schicht 11 aus Halbleitermaterial eines Leitfähigkeitstyps, einer Schicht 13 aus Halbleitermaterial des anderen Leitfähigkeitstyps und einer aktiven Schicht 12 zur Erzeugung von Photonen, die zwischen der Schicht 11 und Schicht 13 angeordnet ist.

Als Ebene 100 der parallel zueinander angeordneten Schichten 11, 12 und 13 ist eine zentrale Schichtebene der aktiven Schicht 12 genommen.

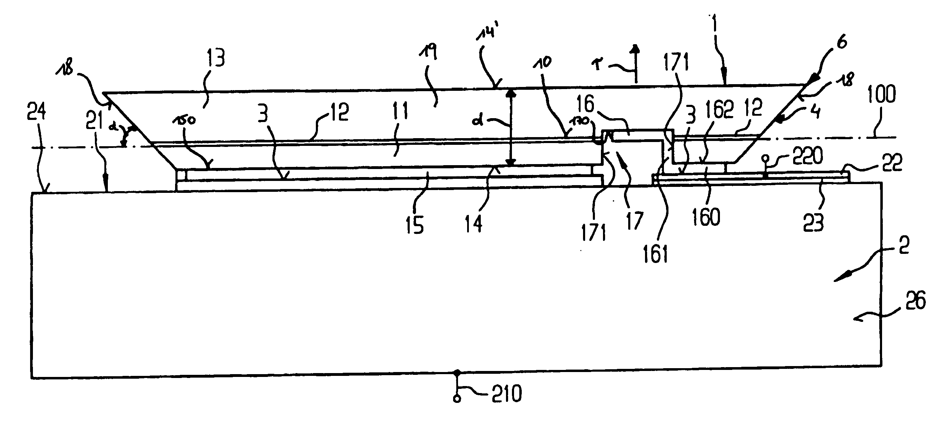

Der Schichtenstapel 1 ist in der Figur 1 so dargestellt, daß die Ebene 100 der Schichten horizontal und senkrecht zur Zeichenebene angeordnet ist.

Der Photonen erzeugende optisch aktive Übergang ist mit 10 bezeichnet, befindet sich zwischen der Schicht 11 und der Schicht 13 und erstreckt sich parallel zur Ebene 100 der Schichten. Zum Übergang 10 ist die aktive Schicht 12 zu zählen.

Die Zahl der epitaktisch gewachsenen Schichten des Schichtenstapels 1 ist nicht auf drei beschränkt und kann größer sein. Beispielsweise können die Schichten 11, 12 und 13 jeweils laminiert sein.

Das Halbleitermaterial der Schichten 11 und 13 des Schichtenstapels 1 so gewählt, daß es für in der zwischen diesen Schichten 11 und 12 angeordneten aktiven Schicht 12 erzeugte Photonen transparent ist.

Bei dem dargestellten Beispiel sind Trägerkörper 2 und Schichtenstapel 1 relativ zueinander so angeordnet, daß eine dem Stapel 1 zugekehrte Oberfläche 24 des Trägerkörpers 2 und die Ebene 100 der Schichten des Stapels 1 im wesentlichen parallel zueinander sind. Von den beiden voneinander abgekehrten Oberflächen 14 und 14' des Trägerkörpers 2 liegt die Oberfläche 14 der Oberfläche 24 des Trägerkörpers 2 gegenüber.

Da der Trägerkörper 2 aus elektrisch leitendem Material besteht, beispielsweise Metall, muss der Kontakt 22 von der Oberfläche 24 isoliert sein. Er muss fest mit der Oberfläche 24 verbunden sein, beispielsweise mittels Klebstoffs oder durch Aufdampfen.

Der Schichtenstapel 1 ist beispielsweise so angeordnet, daß sich die Schicht 11 zwischen dem Trägerkörper 2 und dem optisch aktiven Übergang 10 befindet, wobei die der Oberfläche 24 des Trägerkörpers 2 gegenüberliegende Oberfläche 14 des Schichtenstapels 1 aus dem Halbleitermaterial dieser Schicht 11 besteht.

Auf dieser Oberfläche 14 des Schichtenstapels 1 sind ein Halbleiterkontakt 15, der das Halbleitermaterial der Schicht 11 des Stapels 1 unmittelbar kontaktiert, und ein anderer Kontakt 160, der elektrisch vom Halbleiterkontakt 15 und dem Halbleitermaterial der Schicht 11 getrennt ist, angeordnet. Der Halbleiterkontakt 15 ist vorzugsweise ein ohmscher Kontakt, könnte aber je nach Aufbau des Schichtenstapels 1 auch beispielsweise ein Schottky-Kontakt sein.

Der Halbleiterkontakt 15 liegt unmittelbar auf dem Kontakt 21 und der andere Kontakt 160 unmittelbar auf dem Kontakt 22 des Trägerkörpers 2 auf. Es könnte auch umgekehrt sein.

In der Oberfläche 14 des Stapels 1 ist eine Vertiefung 17 ausgebildet, die sich von dieser Oberfläche 14 in Richtung r senkrecht zur Ebene 100 der Schichten in die Tiefe des Schichtenstapels 1 bis in die Schicht 13 erstreckt, d.h. in das Halbleitermaterial des vom einen Leitfähigkeitstyp des Halbleitermaterials der Schicht 11 verschiedenen anderen Leitfähigkeitstyps, das sich im Unterschiched zu dem sich zwischen der Oberfläche 14 und dem Übergang 10 des Stapels 1 befindenden Halbleitermaterial der Schicht 11 auf der von dieser Oberfläche 14 abgekehrten Seite des optisch aktiven Übergangs 10 befindet.

In der Vertiefung 17 ist ein Halbleiterkontakt 16 angeordnet, der das Halbleitermaterial des anderen Leitfähigkeitstyps der Schicht 13 unmittelbar kontaktiert, beispielsweise auf einer Bodenfläche 170 der Vertiefung 17, und der vorzugsweise ein ohmscher Kontakt ist. Dieser Halbleiterkontakt 16 ist elektrisch mit dem anderen Kontakt 160 verbunden, beispielsweise durch eine elektrische Verbindungsleitung 161.

Der Halbleiterkontakt 16, die elektrische Verbindungsleitung 161 und der andere Kontakt 160 müssen elektrisch vom Halbleitermaterial der Schicht 11, dem dieses Material kontaktierenden Halbleiter-Anschluß-kontakt 15 und dem Kontakt 21 des Trägerkörpers 2 getrennt sein.

Der andere Kontakt 160 und die elektrische Verbindungsleitung 161 können vorteilhafterweise aus dem gleichen Material wie der Halbleiterkontakt 16 bestehen. Die elektrische Verbindungsleitung 161 kann auf einer der seitlichen Wandflächen 171 der Vertiefung 17 aufgebracht sein.

Die elektrische Trennung des anderen Kontakts 160 und der Verbindungsleitung 161 vom Halbleitermaterial der Schicht 11 des Stapels 1 kann durch eine elektrisch isolierende Klebstoffschicht 162 zwischen der Schicht 11 und dem anderen Kontakts 160 sowie der Verbindungsleitung 161 realisiert sein, die auch die feste Verbindung des anderen Kontakts 160 mit dem Schichtenstapel herstellt.

Bei dem dargestellten Beispiel besteht die Schicht 11 aus p-dotiertem Halbleitermaterial, d.h. Material vom Leitfähigkeitstyp p, und die Schicht 13 aus n-dotiertem Halbleitermaterial, d.h Material vom Leitfähigkeitstyp n. Es könnte auch umgekehrt sein, d.h. die Schicht 11 aus n-dotiertem und die Schicht 13 aus p-dotiertem Halbleitermaterial bestehen.

In jedem Fall sollte das Halbleitermaterial der Schicht 13 auf der vom Trägerkörper 2 abgekehrten Seite des Übergangs 10 des Schichtenstapels 1 eine höhere elektrische Leitfähigkeit senkrecht zur Ebene 100 der Schichten aufweist als das Halbleitermaterial der Schicht 11 zwischen dem Übergang 10 und dem Trägerkörper 2.

Das gesonderte Verbindungsmittel 3 zur Befestigung des dünnen Schichtenstapels 1 an dem Trägerkörper 2 besteht beispielsweise im wesentlichen aus einem elektrisch leitenden Klebstoff und/oder einem Lot, das den mit der Schicht 11 verbundenen Halbleiterkontakt 15 des Schichtenstapels 1 fest mit dem zugeordneten Kontakt 21 des Trägerkörpers 2 und den ebenfalls fest mit der Schicht 11 verbundenen anderen Kontakt 160 des Stapels 1 fest mit dem zugeordneten Kontakt 22 des Trägerkörpers 2 verbindet. Vorraussetzung bei dieser bevorzugten Art der Herstellung einer festen Verbindung zwischen Schichtenstapel 1 und Trägerkörper 2 über Kontakte ist die gegebene feste Verbindung des Halbleiterkontakts 15 und anderen Kontakt 160 mit dem Schichtenstapel 1 und des Kontakts 22 mit dem Trägerkörper 2.

Die Befestigung des Schichtenstapels 1 mit dem Trägerkörper 2 muß nicht über Kontakte hergestellt werden. Beispielsweise könnten die einander gegenüberliegenden Oberflächen 14 und 24 des Stapels 1 und Trägerkörpers 2 an kontaktfreien Stellen direkt durch ein Verbindungsmittel 3, beispielsweise einen geeigneten Klebstoff fest miteinander verbunden sein.

Der Schichtenstapel 1 weist zwei voneinander abgekehrte und senkrecht oder schräg in einem Winkel zur Ebene 100 der Schichten stehende Endflächen 19 auf, welche die Oberfläche 14 des Schichtenstapels 1, in der die Vertiefung 17 ausgebildet ist, auf zueinander entgegengesetzten Seiten begrenzen, und die Vertiefung 17 erstreckt sich in dieser Oberfläche 14 von einer dieser beiden Endflächen 19 quer über den ganzen Schichtenstapel 1 bis zur anderen Endfläche 19.

Beispielsweise bildet die Vertiefung 17 einen länglichen Graben, der sich sich parallel zur Ebene 100 der Schichten in einer Längsrichtung zwischen den Endflächen 19 erstreckt, die in der Figur 1 senkrecht zur Zeichenebene ist. Die Figur zeigt eine zur Oberfläche 24 senkrechte und zur Zeichenebene parallele Seitenfläche 26 des Trägerkörpers 2 und die Endfläche 19 des Schichtenstapels 1.

Eine an der dem Trägerkörper 2 zugekehrten Oberfläche 14 des Schichtenstapels 1 ausgebildete Reflektoreinrichtung 4 zum Reflektieren von im Schichtenstapel 4 erzeugten und auf diese Fläche 4 treffenden Photonen zurück in den Schichtenstapel 4 besteht beispielsweise aus dem Halbleiterkontakt 15, der auf der dem Trägerkörper 2 zugekehrten Oberfläche 14 des Schichtenstapels 1 ausgebildet ist und der reflektierend wirkt, d.h. seine dem Schichtenstapel 1 zugekehrte Flachseite 150 ist eine spiegelnde Fläche. Dieser Kontakt 15 sollte die dem Trägerkörper 2 zugekehrte Oberfläche 14 des Schichtenstapels 1 möglichst großflächig abdecken, damit möglichst viel Photonen reflektiert und möglichst wenig verlorengehen.

Eine Einrichtung 6 zur Erleichterung eines Austritts von im Schichtenstapel 1 erzeugten Photonen aus dem Schichtenstapel 1 weist schräg in einem Winkel relativ zueinander angeordnete Oberflächenabschnitte auf, die beispielsweise aus schräg in einem Winkel α zur Ebene der Schichten 100 angeordneten Endflächen 18, 18 des Schichtenstapels 1, senkrecht zur Ebene 100 der Schichten angeordneten seitlichen Wandflächen 171, 171 der Vertiefung 17 und in der Ebene 100 der Schichten schräg in einem weiteren Winkel zueinander verlaufenden und schräg oder senkrecht zur Ebene 100 der Schichten angeordneten Endflächen 19, 19 des Schichtenstapels 1 bestehen und jeweils paarweise einander zugeordnet je zwei schräg in einem Winkel relativ zueinander angeordnete Oberflächenabschnitte bilden.

Dies ist jedoch nur ein spezielles Beispiel, die Endflächen 18, 18, 19, 19 und Wandflächen 171, 171 können in jeder anderen Art und Weise schräg in einem Winkel relativ zueinander angeordnet sein. Jedenfalls sollten jeweils zwei voneinander abgekehrte Oberflächenabschnitte - Endflächen und/oder Wandflächen - schräg in einem Winkel zueinander stehen. Letzteres ist gewährleistet, wenn von zwei voneinander abgekehrten Oberflächenabschnitten wenigstens einer schräg in einem Winkel und der andere in einem zu diesem Winkel verschiedenen Winkel schräg oder senkrecht zur Ebene 100 der Schichten angeordnet ist und/oder diese beiden Oberflächenabschnitte in der Ebene 100 der Schichten schräg in einem Winkel zueinander verlaufen.

Außerdem weist die Einrichtung 6 zur Erleichterung des Austritts von Photonen ein auf der Oberfläche des Schichtenstapels 1 ausgebildetes fein strukturiertes Relief auf.

Unter Oberfläche des Schichtenstapels 1 ist dessen gesamte Oberfläche zu verstehen, die aus der dem Trägerkörper 2 zugekehrten Oberfläche 14, der vom Trägerkörper 2 abgekehrten Oberfläche 14' und allen sonstigen Oberflächenabschnitten 18, 19, 170, 171 besteht. Das Relief kann auf jedem dieser Oberflächenabschnitte 18, 19, 170, 171 ausgebildet sein, sollte aber zumindest auf der vom Trägerkörper 2 abgekehrten Oberfläche 14' vorgesehen sein.

Der Winkel α, in welchem eine Endfläche 18, 19 schräg zur Ebene 100 der Schichten angeordnet ist, beträgt vorzugsweise weniger als 30° bei unvergossenen und weniger als 40° bei vergossenen erfindungsgemäßen Lichtquellen, wobei die Richtung der Neigung beliebig ist. Auch eine Wandfläche 171 der Vertiefung 17 kann in schräg in einem solchen Winkel α zur Ebene 100 der Schichten geneigt angeordnet sein.

Wenn der Schichtenstapel 1 aus III-V-Halbleitermaterial und der Trägerkörper 2 aus Silizium besteht, haben beide einen hinreichend ähnlichen thermischen Ausdehnungskoeffizienten und der Trägerkörper 2 ist ausreichend gut wärmeleitend.

Der Trägerkörper 2 besteht aus elektrisch leitendem Material, beispielsweise leitendes Halbleitermaterial wie Silizium oder Metall.

Einer der Kontakte 21 und 22 des Trägerkörpers 2, beispielsweise der Kontakt 22, ist vom Trägerkörper 2 elektrisch isoliert und der elektrisch von diesem Kontakt 22 getrennte andere Kontakt 21 ist durch das Material des Trägerkörpers 2 selbst gebildet.

Der Kontakt 22 des Trägerkörpers 2 ist durch eine elektrisch isolierende Schicht 23, beispielsweise eine Klebstoffschicht, von der Oberfläche 24 des Trägerkörpers 2 isoliert und durch ein elektrisch leitendes Vebindungsmittel 3, beispielsweise Lot oder elektrisch leitender Klebstoff, mit dem anderen Kontakt 160 des Schichtenstapels 1 verbunden. Der Kontakt 21 des Trägerkörpers 2 ist durch dessen Oberfläche 24 selbst gebildet und durch ein elektrisch leitendes Vebindungsmittel 3, beispielsweise Lot oder elektrisch leitender Klebstoff, direkt mit dem Halbleiterkontakt 15 des Schichtenstapels 1 verbunden.

Der vom Trägerkörper 2 elektrisch isolierte Kontakt 22 auf der Oberfläche 24 ist mit einem äußeren Anschlußkontakt 220 und eine von dieser Oberfläche 24 und damit vom Schichtenstapel 1 abgekehrte Oberfläche des Trägerkörpers 2 ist mit einem äußeren Anschlußkontakt 210 versehen, so daß in diesem Fall die Halbleiterlichtquelle von der Rückseite des Trägerkörpers 2 und durch diesen hindurch von außen kontaktiert ist .

Die Herstellung der erfindungsgemäßen Halbleiterlichtquelle erfolgt so, daß auf einem Wachstumssubstrat epitaktisch der für die Lichtquelle bestimmte Schichtenstapel 1 gewachsen wird, der mit dem Wachstumssubstrat verbundene Schichtenstapel 1 auf dem die elektrisch voneinander getrennten Kontakte 21, 22 aufweisenden Trägerkörper 2 angeordnet und mit dem Verbindungsmittel 3 befestigt wird und danach der derart auf dem Trägerkörper 2 befestigte Schichtenstapel 1 vom Wachstumssubstrat getrennt wird.

Demnach ist die dem Trägerkörper 2 zugekehrte Oberfläche 14 des Schichtenstapels 1 die vom Wachstumssubstrat abgekehrte freie Oberfläche des Schichtenstapels 1, die vor der Trennung des Schichtenstapels 1 vom Wachstumssubstrat strukturiert und kontaktiert, z.B. mit der Vertiefung 17 und den Kontakten 15, 16 und 160 einschließlich der Verbindungsleitung 161 versehen wird.

Zum Trennen des Schichtenstapels 1 vom Wachstumssubstrat wird zweckmäßigerweise so vorgegangen, daß vor dem epitaktischen Wachsen der Schichten des Schichtenstapels 1 auf dem Wachstumssubstrat epitaktisch eine Zwischenschicht aus einem Material gewachsen wird, das mit einem selektiv wirkenden Ätzmittel ätzbar ist, welches das Material jeder epitaktisch zu wachsenden Schicht des Schichtenstapels 1, im Beispiel jeder der Schichten 11, 12 und 13, nicht oder weniger stark angreift, als das Material der Zwischenschicht, daß auf der Zwischenschicht epitaktisch die Schichten des Schichtenstapels 1 gewachsen werden und daß zum Trennen des Schichtenstapels 1 vom Wachstumssubstrat die Zwischenschicht mit dem selektiv wirkenden Ätzmittel geätzt wird.

Beispielsweise werden ein Wachstumssubstrat aus GaAs, ein Schichtenstapel 1 auf der Basis von InGaAlAs, eine Zwischenschicht aus AlAs und ein flußsäurehaltiges Ätzmittel verwendet.

Bei der Herstellung der erfindungsgemäßen Halbleiterlichtquellen wird vorteilhafterweise so vorgegangen, daß mehrere Schichtenstapel 1 im Waferverbund als Inseln oder Meseten im Raster mehrerer Trägerkörper 2 präpariert werden, wobei die Form der Grundfläche jedes Schichtenstapels 1 beliebig wählbar ist, vorzugsweise mit spitzwinklig zueinander angeordneten seitlichen Endflächen 19. Die Zwischenschicht ist auf die erhabene Oberfläche der Insel oder des Mesa angeordnet.

Zur Bildung der Meseten oder Inseln 50 wird vorzugsweise so vorgegangen, daß auf die Oberfläche des Wafers die Zwischenschicht 51 und die Schichten des Schichtenstapels 1 ganzflächig epitaktisch aufgewachsen und danach aus der beschichteten Oberfläche die Inseln 50 herausgeätzt werden.

## Patentansprüche

1. Halbleiterlichtquelle mit einem aus epitaktisch aufeinander gewachsenen Schichten (11, 12, 13) aus Halbleitermaterial bestehenden Schichtenstapel (1) zur Erzeugung und Abstrahlung von Photonen als optische Leistung der Lichtquelle, wobei der Schichtenstapel (1)
- von einem Wachstumssubstrat (5) frei ist,
- elektrisch kontaktiert ist,
- eine Gesamtdicke (d) von höchstens 50 µm aufweist,
- an einem gesonderten Trägerkörper (2) angeordnet,
- mittels eines gesonderten Verbindungsmittels (3) fest mit dem Trägerkörper (2) verbunden und
- elektrisch am Trägerkörper (2) angeschlossen ist
**dadurch gekennzeichnet, dass**
- der Trägerkörper (2) aus elektrisch leitendem Material besteht,
- ein Kontakt (22) des Trägerkörpers (2) vom Trägerkörper (2) elektrisch isoliert ist und
- ein elektrisch von diesem Kontakt (22) getrennter anderer Kontakt (21) des Trägerkörpers (2) vom den Trägerkörper (2) selbst gebildet ist.

2. Lichtquelle nach Anspruch 1, **dadurch gekennzeich**ne t, daß an einer dem Trägerkörper (2) zugekehrten Oberfläche (14) des Schichtenstapels (1) eine Reflektoreinrichtung (4) zum Reflektieren von im Schichtenstapel (1) erzeugten und auf diese Fläche (14) treffenden Photonen zurück in den Schichtenstapel (1) ausgebildet ist.

3. Lichtquelle nach Anspruch 2, **dadurch gekennzeich**ne t, daß die Reflektoreinrichtung (4) einen auf der dem Trägerkörper (2) zugekehrten Oberfläche (14) des Schichtenstapels (1) angeordneten reflektierenden Kontakt (15) aufweist.

4. Lichtquelle nach Anspruch 1, **dadurch gekennzeichnet, daß** der Schichtenstapel (1) eine Gesamtdicke (d) im Bereich von 3 µm bis 15 µm aufweist.

5. Lichtquelle nach einem der vorhergehenden Ansprüche, **gekennzeichnet durch** einen Schichtenstapel (1) einer Infrarotdiode.

6. Lichtquelle nach einem der vorhergehenden Ansprüche, **gekennzeichnet durch** einen Schichtenstapel (1) einer Leuchtdiode.

7. Lichtquelle nach einem der vorhergehenden Ansprüche, **dadurch gekennzeichnet, daß** das gesonderte Verbindungsmittel (3) aus einem eine feste Verbindung zwischen dem Schichtenstapel (1) und dem davon getrennten Trägerkörper (2) herstellenden Haftmittel besteht.

8. Lichtquelle nach Anspruch 7, **dadurch gekennzeichnet, daß** das Verbindunsmittel (3) aus einem Klebstoff besteht.

9. Lichtquelle nach Anspruch 7 oder 8, **dadurch gekennzeichnet, daß** das Verbindungsmittel (3) aus einem Lot besteht.

10. Lichtquelle nach einem der vorhergehenden Ansprüche, **dadurch gekennzeichnet, daß**
- der Schichtenstapel (1) Schichten (11, 12, 13) aus Halbleitermaterial voneinander verschiedenen Leitfähigkeitstyps (p, n) aufweist, zwischen denen ein optisch aktiver Übergang (10) von einem (p; n) zum anderen Leitfähigkeitstyp (n; p) zur Erzeugung der Photonen ausgebildet ist, und daß
- Halbleitermaterial eines Leitfähigkeitstyps (p; n) des Schichtenstapels (1) und Halbleitermaterial des anderen Leitfähigkeitstyps (n; p) elektrisch voneinander getrennt am Trägerkörper (2) angeschlossen sind.

11. Lichtquelle nach Anspruch 10, **dadurch gekennzeichnet, daß**
- das Halbleitermaterial eines Leitfähigkeitstyps (p; n) des Schichtenstapels (1) an einen der elektrischen Kontakte (21; 22) des Trägerkörpers (2) angeschlossen ist, und
- das Halbleitermaterial des anderen Leitfähigkeitstyps (n; p) des Schichtenstapels (1) an den vom einen Kontakt (21; 22) getrennten anderen elektrischen Kontakt (22; 21) des Trägerkörpers (2) angeschlossen ist.

12. Lichtquelle nach einem der vorhergehenden Ansprüche, **dadurch gekennzeichnet, daß** Halbleitermaterial des Schichtenstapels (1) durch einen dieses Halbleitermaterial unmittelbar kontaktierenden Halbleiterkontakt (15, 16) elektrisch mit einem der elektrischen Kontakte (21, 22) des Trägerkörpers (2) verbunden ist.

13. Lichtquelle nach Anspruch 11 und 12, **dadurch gekennzeichnet, daß**
- der Schichtenstapel (1) eine zu einer Ebene (100) der Schichten (11, 12, 13) im wesentlichen parallele Oberfläche (14) aufweist, in der eine Vertiefung (17) ausgebildet ist, die sich von dieser Oberfläche (14) in Richtung (r) senkrecht zur Ebene (100) der Schichten (11, 12, 13) in die Tiefe des Schichtenstapels (1) bis zu Halbleitermaterial erstreckt, das sich auf der von dieser Oberfläche (14) abgekehrten Seite des optisch aktiven Übergangs (10) befindet und eines anderen Leitfähigkeitstyps (n; p) ist als ein Leitfähigkeitstyp (p; n) von Halbleitermaterial des Schichtenstapels (1), das sich zwischen dieser Oberfläche (14) und dem Übergang (10) befindet, und daß
- das Halbleitermaterial des einen Leitfähigkeitstyps (p; n) zwischen dieser Oberfläche (14) und dem Übergang (10) an einen der elektrischen Kontakte (21; 22) des Trägerkörpers (2) und das Halbleitermaterial des anderen Leitfähigkeitstyps (n; p) auf der von dieser Oberfläche (14) abgekehrten Seite des Übergangs (10) in der Vertiefung (17) an den elektrisch von diesem einen Kontakt (21; 22) des Trägerkörpers (2) getrennten anderen Kontakt (22; 21) des Trägerkörpers (2) angeschlossen ist.

14. Lichtquelle nach Anspruch 13,**dadurch gekennzeichnet, daß** die Oberfläche (14) des Schichtenstapels (1), in der die Vertiefung (17) ausgebildet ist, dem Trägerkörper (2) zugekehrt ist.

15. Lichtquelle nach Anspruch 13 oder 14, **dadurch gekennzeichnet, daß** der Schichtenstapel (1) voneinander abgekehrte und in einem Winkel zur Ebene (100) der Schichten (11, 12, 13) stehende Endflächen (19) aufweist, welche die Oberfläche (14) des Schichtenstapels (1), in der die Vertiefung (17) ausgebildet ist, auf zueinander entgegengesetzten Seiten begrenzen, und daß sich die Vertiefung (17) in dieser Oberfläche (14) von einer Endfläche (19) bis zur anderen (19) erstreckt.

16. Lichtquelle nach einem der Ansprüche 13 bis 15, **dadurch gekennzeichnet, daß** auf der vom Trägerkörper (2) abgekehrten Seite des optisch aktiven Übergangs (10) befindliches Halbleitermaterial des Schichtenstapels (1) eine hohe elektrische Leitfähigkeit senkrecht zur Ebene (100) der Schichten (11, 12, 13) des Schichtenstapels (1) aufweist.

17. Lichtquelle nach einem der vorhergehenden Ansprüche, **dadurch gekennzeichnet, daß** die Schichten (11, 12, 13) des Schichtenstapels (1), allenfalls ausgenommen in einem Bereich (12) des optisch aktiven Übergangs (10), für in diesem Übergang (10) erzeugte Photonen transparent sind.

18. Lichtquelle nach einem der vorhergehenden Ansprüche, **dadurch gekennzeichnet, daß** eine Einrichtung (6) zur Erleichterung eines Austritts von im Schichtenstapel (1) erzeugten Photonen aus dem Schichtenstapel (1) vorgesehen ist.

19. Lichtquelle nach Anspruch 18, **dadurch gekennzeichnet, daß** die Einrichtung (6) zur Erleichterung des Austritts von Photonen schräg in einem Winkel relativ zueinander angeordnete Oberflächenabschnitte (18, 170; 18, 171; 18, 18; 19, 19) aufweist.

20. Lichtquelle nach Anspruch 18 oder 19, **dadurch gekennzeichnet, daß** die Einrichtung (6) zur Erleichterung des Austritts von Photonen ein auf der Oberfläche (14, 14', 18, 19) des Schichtenstapels (1) ausgebildetes Relief (61) aufweist.

21. Lichtquelle nach einem der vorhergehenden Ansprüche, **dadurch gekennzeichnet, daß** der optisch aktive Übergang (10) eine aktive Schicht (12) des Schichtenstapels (1) aufweist, in der Photonen erzeugbar sind.

22. Lichtquelle nach einem der vorhergehenden Ansprüche, **dadurch gekennzeichnet, daß** der Schichtenstapel (1) III-V-Halbleitermaterial aufweist.

23. Lichtquelle nach einem der vorhergehenden Ansprüche, **dadurch gekennzeichnet, daß** der Trägerkörper (2) aus einem Material besteht, das einen ähnlichen thermischen Ausdehnungskoeffizienten wie der Schichtenstapel (1) aufweist.

24. Lichtquelle nach einem der vorhergehenden Ansprüche, **dadurch gekennzeichnet, daß** der Trägerkörper (2) aus einem gut wärmeleitenden Material (1) besteht.

25. Lichtquelle nach nach einem der vorhergehenden Ansprüche, **dadurch gekennzeichnet, daß** der vom Trägerkörper (2) elektrisch isolierte Kontakt (21; 22) und eine vom Schichtenstapel (1) abgekehrte Oberfläche (25) des Trägerkörpers (2) von außen kontaktiert ist.

26. Verfahren zur Herstellung einer Halbleiterlichtquelle, **dadurch gekennzeichnet, daß** auf einem Wachstumssubstrat (5) epitaktisch ein für die Lichtquelle bestimmter Schichtenstapel (1) gewachsen wird, der mit dem Wachstumssubstrat (5) verbundene Schichtenstapel (1) auf einem Trägerkörper (2) angeordnet und mit einem Verbindungsmittel (3) befestigt wird, und danach der derart auf dem Trägerkörper (2) befestigte Schichtenstapel (1) vom Wachstumssubstrat (5) getrennt wird, wobei der Trägerkörper (2) aus elektrisch leitendem Material besteht, ein Kontakt (22) des Trägerkörpers (2) vom Trägerkörper (2) elektrisch isoliert ist und ein elektrisch von dem einen Kontakt (22) getrennter anderer Kontakt (21) des Trägerkörpers (2) von dem Trägerkörper (2) selbst gebildet wird.

27. Verfahren nach Anspruch 26, **dadurch gekennzeichnet, daß**
- auf dem Wachstumssubstrat (5) epitaktisch eine Zwischenschicht (51) aus einem Material gewachsen wird, das mit einem selektiv wirkenden Ätzmittel ätzbar ist, welches das Material jeder epitaktisch zu wachsenden Schicht (11, 12, 13) des Schichtenstapels (1) nicht oder weniger stark angreift, als das Material der Zwischenschicht (51),
- auf der Zwischenschicht (51) epitaktisch die Schichten (11, 12, 13) des Schichtenstapels (1) gewachsen werden, und
- zum Trennen des Schichtenstapels vom Wachstumssubstrat (5) die Zwischenschicht (51) mit dem selektiv wirkenden Ätzmittel geätzt wird.

## Claims

1. Semiconductor light source comprising a layer stack (1) consisting of layers (11, 12, 13) of semiconductor material grown epitaxially one on top of another, for generating and emitting photons as optical power of the light source, wherein the layer stack (1)
- is free of a growth substrate (5),
- is electrically contact-connected,
- has a total thickness (d) of at most 50 µm,
- is arranged at a separate carrier body (2),
- is fixedly connected to the carrier body (2) by means of a separate connecting means (3), and
- is electrically connected to the carrier body (2),
**characterized in that**
- the carrier body (2) consists of electrically conductive material,
- one contact (22) of the carrier body (2) is electrically insulated from the carrier body (2), and
- another contact (21) - electrically isolated from said contact (22) - of the carrier body (2) is formed by the carrier body (2) itself.

2. Light source according to Claim 1, **characterized in that** a reflector device (4) is formed at a surface (14) of the layer stack (1) which faces the carrier body (2), said reflector device serving for reflecting photons that are generated in the layer stack (1) and impinge on said surface (14) back into the layer stack (1).

3. Light source according to Claim 2, **characterized in that** the reflector device (4) has a reflective contact (15) arranged on the surface (14) of the layer stack (1) which faces the carrier body (2).

4. Light source according to Claim 1, **characterized in that** the layer stack (1) has a total thickness (d) in the range of 3 µm to 15 µm.

5. Light source according to any of the preceding claims, **characterized by** a layer stack (1) of an infrared diode.

6. Light source according to any of the preceding claims, **characterized by** a layer stack (1) of a light-emitting diode.

7. Light source according to any of the preceding claims, **characterized in that** the separate connecting means (3) consists of an adhesion means that produces a fixed connection between the layer stack (1) and the carrier body (2) separated therefrom.

8. Light source according to Claim 7, **characterized in that** the connecting means (3) consists of an adhesive.

9. Light source according to Claim 7 or 8, **characterized in that** the connecting means (3) consists of a solder.

10. Light source according to any of the preceding claims, **characterized in that**
- the layer stack (1) has layers (11, 12, 13) of semiconductor material having mutually different conductivity types (p, n), between which is formed an optically active junction (10) from one (p; n) to the other conductivity type (n; p) for generating the photons, and **in that**
- semiconductor material of one conductivity type (p; n) of the layer stack (1) and semiconductor material of the other conductivity type (n; p) are connected to the carrier body (2) in a manner electrically isolated from one another.

11. Light source according to Claim 10, **characterized in that**
- the semiconductor material of one conductivity type (p; n) of the layer stack (1) is connected to one of the electrical contacts (21; 22) of the carrier body (2), and
- the semiconductor material of the other conductivity type (n; p) of the layer stack (1) is connected to the other electrical contact (22; 21) - isolated from said one contact (21; 22) - of the carrier body (2).

12. Light source according to any of the preceding claims, **characterized in that** semiconductor material of the layer stack (1) is electrically connected to one of the electrical contacts (21, 22) of the carrier body (2) by a semiconductor contact (15, 16) that directly makes contact with said semiconductor material.

13. Light source according to Claims 11 and 12, **characterized in that**
- the layer stack (1) has a surface (14) which is substantially parallel to a plane (100) of the layers (11, 12, 13) and in which is formed a depression (17) extending from said surface (14) in a direction (r) perpendicular to the plane (100) of the layers (11, 12, 13) into the depth of the layer stack (1) as far as semiconductor material which is situated on that side of the optically active junction (10) which faces away from said surface (14), and is of a different conductivity type (n; p) from a conductivity type (p; n) of semiconductor material of the layer stack (1) which is situated between said surface (14) and the junction (10), and **in that**
- the semiconductor material of said one conductivity type (p; n) between said surface (14) and the junction (10) is connected to one of the electrical contacts (21; 22) of the carrier body (2) and the semiconductor material of the other conductivity type (n; p) on that side of the junction (10) which faces away from said surface (14) in the depression (17) is connected to the other contact (22; 21) of the carrier body (2), said other contact being electrically isolated from said one contact (21; 22) of the carrier body (2).

14. Light source according to Claim 13, **characterized in that** the surface (14) of the layer stack (1) in which the depression (17) is formed faces the carrier body (2).

15. Light source according to Claim 13 or 14, **characterized in that** the layer stack (1) has end areas (19) which face away from one another and are at an angle with respect to the plane (100) of the layers (11, 12, 13), which end areas delimit the surface (14) of the layer stack (1) in which the depression (17) is formed on mutually opposite sides, and **in that** the depression (17) in said surface (14) extends from one end area (19) as far as the other end area (19).

16. Light source according to any of Claims 13 to 15, **characterized in that** semiconductor material of the layer stack (1) which is situated on that side of the optically active junction (10) which faces away from the carrier body (2) has a high electrical conductivity perpendicular to the plane (100) of the layers (11, 12, 13) of the layer stack (1).

17. Light source according to any of the preceding claims, **characterized in that** the layers (11, 12, 13) of the layer stack (1), at most apart from in a region (12) of the optically active junction (10), are transparent to photons generated in said junction (10).

18. Light source according to any of the preceding claims, **characterized in that** a device (6) for facilitating an emergence of photons generated in the layer stack (1) from the layer stack (1) is provided.

19. Light source according to Claim 18, **characterized in that** the device (6) for facilitating the emergence of photons has surface sections (18; 170; 18, 171; 18, 18; 19, 19) arranged obliquely at an angle relative to one another.

20. Light source according to Claim 18 or 19, **characterized in that** the device (6) for facilitating the emergence of photons has a relief (61) formed on the surface (14, 14', 18, 19) of the layer stack (1).

21. Light source according to any of the preceding claims, **characterized in that** the optically active junction (10) has an active layer (12) of the layer stack, in which photons can be generated.

22. Light source according to any of the preceding claims, **characterized in that** the layer stack (1) comprises III - V semiconductor material.

23. Light source according to any of the preceding claims, **characterized in that** the carrier body (2) consists of a material having a coefficient of thermal expansion similar to that of the layer stack (1).

24. Light source according to any of the preceding claims, **characterized in that** the carrier body (2) consists of a material (1) having good thermal conductivity.

25. Light source according to any of the preceding claims, **characterized in that** the contact (21; 22) that is electrically insulated from the carrier body (2) and a surface (25) of the carrier body (2) which faces away from the layer stack (1) are contact-connected externally.

26. Method for producing a semiconductor light source, **characterized in that** a layer stack (1) intended for the light source is grown epitaxially on a growth substrate (5), the layer stack (1) connected to the growth substrate (5) is arranged on a carrier body (2) and is fixed with a connecting means (3), and the layer stack (1) fixed on the carrier body (2) in this way is then separated from the growth substrate (5), wherein the carrier body (2) consists of electrically conductive material, one contact (22) of the carrier body (2) is electrically insulated from the carrier body (2), and another contact (21) - electrically isolated from said one contact (22) - of the carrier body (2) is formed by the carrier body (2) itself.

27. Method according to Claim 26, **characterized in that**
- an interlayer (51) is grown epitaxially on the growth substrate (5), said interlayer being composed of a material which can be etched using a selectively acting etchant by which the material of each layer (11, 12, 13) of the layer stack (1) that is to be grown epitaxially is not attacked or is attacked to a lesser extent than the material of the interlayer (51),
- the layers (11, 12, 13) of the layer stack (1) are grown epitaxially on the interlayer (51), and
- in order to separate the layer stack from the growth substrate (5), the interlayer (51) is etched using the selectively acting etchant.

## Revendications

1. Source de lumière à semi-conducteur qui présente un empilement (1) de couches de croissance (11, 12, 13) en matériau semi-conducteur, qui produit et émet des photons qui constituent la puissance optique de la source de lumière, l'empilement (1) de couches :
- étant séparé d'un substrat de croissance (5),
- étant doté de contacts électriques,
- ayant une épaisseur totale (d) d'au plus 50 µm,
- étant disposé sur un corps de support (2) séparé,
- étant relié solidairement au corps de support (2) au moyen d'un moyen séparé de liaison (3) et
- étant raccordé électriquement au corps de support (2),
**caractérisée en ce que**
- le corps de support (2) est constitué d'un matériau électriquement conducteur,
- un contact (22) du corps de support (2) est électriquement isolé du corps de support (2) et
- un autre contact (21) du corps de support (2), séparé électriquement de ce contact (22), est formé par le corps de support (2) proprement dit.

2. Source de lumière selon la revendication 1, **caractérisée en ce qu'**une couche réfléchissante (4) qui réfléchit dans l'empilement (1) de couches les photons produits dans l'empilement (1) de couches et incidents sur cette surface (14) est formée sur une surface (14) de l'empilement (1) de couches tournée vers le corps de support (2).

3. Source de lumière selon la revendication 2, **caractérisée en ce que** le dispositif réfléchissant (4) présente un contact réfléchissant (15) disposé sur la surface (14) de l'empilement (1) de couches tournée vers le corps de support (2).

4. Source de lumière selon la revendication 1, **caractérisée en ce que** l'empilement (1) de couches présente une épaisseur totale (d) de l'ordre de 3 µm à 15 µm.

5. Source de lumière selon l'une des revendications précédentes, **caractérisée par** un empilement (1) de couches d'une diode infrarouge.

6. Source de lumière selon l'une des revendications précédentes, **caractérisée par** un empilement (1) de couches d'une diode luminescente.

7. Source de lumière selon l'une des revendications précédentes, **caractérisée en ce que** le moyen séparé de liaison (3) est constitué d'un moyen d'adhérence qui établit une liaison solidaire entre l'empilement (1) de couches et le corps du support (2) qui en est séparé.

8. Source de lumière selon la revendication 7, **caractérisée en ce que** le moyen de liaison (3) est constitué d'un adhésif.

9. Source de lumière selon les revendications 7 ou 8, **caractérisée en ce que** le moyen de liaison (3) est constitué d'une brasure.

10. Source de lumière selon l'une des revendications précédentes, **caractérisée en ce que**
- l'empilement (1) de couches présente des couches (11, 12, 13) en matériaux semi-conducteurs qui présentent des types de conductivité (p, n) différents les uns des autres et entre lesquels une transition optiquement active (10) d'un type de conductivité (p ; n) à l'autre type de conductivité (n ; p) est formée pour produire des photons et
- **en ce que** le matériau semi-conducteur d'un type de conductivité (p ; n) de l'empilement (1) de couches et le matériau semi-conducteur de l'autre type de conductivité (n ; p) sont raccordés au corps de support (2) de manière électriquement séparée l'un de l'autre.

11. Source de lumière selon la revendication 10, **caractérisée en ce que**
- le matériau semi-conducteur d'un type de conductivité (p ; n) de l'empilement (1) de couches est raccordé à un des contacts électriques (21 ; 22) du corps de support (2) et
- **en ce que** le matériau semi-conducteur de l'autre type de conductivité (n ; p) de l'empilement (1) de couches est raccordé à l'autre contact électrique (21 ; 22), séparé du premier contact (22 ; 21), du corps de support (2).

12. Source de lumière selon l'une des revendications précédentes, **caractérisée en ce que** le matériau semi-conducteur de l'empilement (1) de couches est relié électriquement à un des contacts électriques (21, 22) du corps de support (2) par un contact semi-conducteur (15, 16) qui assure le contact direct avec ce matériau semi-conducteur.

13. Source de lumière selon les revendications 11 et 12, **caractérisé en ce que**
- l'empilement (1) de couches présente une surface (14) essentiellement parallèle à un plan (100) des couches (11, 12, 13) et dans laquelle est formé un creux (17) qui, partant de cette surface (14), s'étend dans une direction (r) perpendiculaire au plan (100) des couches (11, 12, 13) dans l'épaisseur de l'empilement de couches (1) jusqu'au matériau semi-conducteur situé sur le côté de la transition optiquement active (10) non tourné vers cette surface (14) et d'un autre type de conductivité (n ; p) que le type de conductivité (p ; n) du matériau semi-conducteur de l'empilement (1) de couches situé entre cette surface (14) et la transition (10) et
- **en ce que** le matériau semi-conducteur d'un type de conductivité (p ; n) situé entre cette surface (14) et la transition (10) est raccordé à un des contacts électriques (21 ; 22) du corps de support (2), le matériau semi-conducteur de l'autre type de conductivité (n ; p) situé sur le côté de la transition (10) non tourné vers cette surface (14) et dans le creux (17) est raccordé à l'autre contact (22 ; 21) du corps de support (2), séparé électriquement de ce contact (21 ; 22) du corps de support (2).

14. Source de lumière selon la revendication 13, **caractérisée en ce que** la surface (14) de l'empilement (1) de couches dans laquelle le creux (17) est formé est tournée vers le corps de support (2).

15. Source de lumière selon les revendications 13 ou 14, **caractérisée en ce que** l'empilement (1) de couches présente des surfaces d'extrémité (19) non tournées l'une vers l'autre, formant un angle par rapport au plan (100) des couches (11, 12, 13) et délimitant sur des côtés mutuellement opposés la surface (14) de l'empilement (1) de couches dans laquelle est formé le creux (17) et **en ce que** le creux (17) s'étend dans cette surface (14) depuis une surface d'extrémité (19) jusqu'à l'autre (19).

16. Source de lumière selon l'une des revendications 13 à 15, **caractérisée en ce que** le matériau semi-conducteur de l'empilement (1) de couches situé sur le côté de la transition optiquement active (10) non tourné vers le corps de support (2) présente une haute conductivité électrique perpendiculairement au plan (100) des couches (11, 12, 13) de l'empilement (1) de couches.

17. Source de lumière selon l'une des revendications précédentes, **caractérisée en ce qu'**en tout cas à l'exception d'une partie (12) de la transition optiquement active (10), les couches (11, 12, 13) de l'empilement (1) de couches sont transparentes aux photons produits dans cette transition (10).

18. Source de lumière selon l'une des revendications précédentes, **caractérisée en ce qu'**elle présente un dispositif (6) qui facilite la sortie hors de l'empilement (1) de couches des photons produits dans l'empilement (1) de couches.

19. Source de lumière selon la revendication 18, **caractérisée en ce que** le dispositif (6) qui facilite la sortie des photons présente des parties de surface (18, 170 ; 18, 171 ; 18, 18 ; 19, 19) disposées à un angle oblique les unes par rapport aux autres.

20. Source de lumière selon les revendications 18 ou 19, **caractérisée en ce que** le dispositif (6) qui facilite la sortie des photons présente un relief (61) formé sur la surface (14, 14', 18, 19) de l'empilement (1) de couches.

21. Source de lumière selon l'une des revendications précédentes, **caractérisée en ce que** la transition optiquement active (10) présente une couche active (12) de l'empilement (1) de couches dans lequel des photons peuvent être produits.

22. Source de lumière selon l'une des revendications précédentes, **caractérisée en ce que** l'empilement (1) de couches présente un matériau semi-conducteur III-V.

23. Source de lumière selon l'une des revendications précédentes, **caractérisée en ce que** le corps de support (2) est constitué d'un matériau dont le coefficient de dilatation thermique est similaire à celui de l'empilement (1) de couches.

24. Source de lumière selon l'une des revendications précédentes, **caractérisée en ce que** le corps de support (2) est constitué d'un matériau (1) bon conducteur de la chaleur.

25. Source de lumière selon l'une des revendications précédentes, **caractérisée en ce que** le contact (21 ; 22) isolé électriquement du corps de support (22) et une surface (25) du corps de support (2) non tournée vers l'empilement (1) de couches sont mis en contact avec l'extérieur.

26. Procédé de fabrication d'une source de lumière à semi-conducteur, **caractérisé en ce que** sur un substrat de croissance (5), on fait croître par épitaxie un empilement (1) de couches qui convient pour la source de lumière, on dispose sur un corps de support (2) l'empilement (1) de couches relié au substrat de croissance (5) et on l'y fixe à l'aide d'un moyen de liaison (3), on sépare du substrat de croissance (5) l'empilement (1) de couches ainsi fixé sur le corps de support (2), le corps de support (2) étant constitué d'un matériau électriquement conducteur, un contact (22) du corps de support (2) étant isolé électriquement du corps de support (2) et un autre contact (21) du corps de support (2), séparé électriquement du premier contact (22), étant formé par le corps de support (2) proprement dit.

27. Procédé selon la revendication 26, **caractérisé en ce que**
- on fait croître par épitaxie sur le substrat de croissance (5) une couche intermédiaire (51) en un matériau qui peut être gravé par un agent de gravure agissant sélectivement et qui n'attaque ou attaque moins le matériau de chaque couche (11, 12, 13) de l'empilement (1) de couches à faire croître par épitaxie que le matériau de la couche intermédiaire (51),
- **en ce que** l'on fait croître les couches (11, 12, 13) de l'empilement (1) de couches par épitaxie sur la couche intermédiaire (51) et
- **en ce que** pour séparer l'empilement de couches du substrat de croissance (5), on attaque la couche intermédiaire (51) avec l'agent de gravure à action sélective.
